# EUROPEAN PATENT APPLICATION

(11) **EP 3 196 948 A1**
(43) Date of publication of application: **26.07.2017**
(21) Application number: 15841892.1
(22) Date of filing: 27.08.2015
(51) Int. Cl.: H01L 31/054, G02B 5/02, H01L 31/0236

(54) **SOLAR CELL MODULE**

(30) Priority: 17.09.2014 JP 2014188833
(71) Applicant: Kaneka Corporation, Osaka-shi, Osaka 530-8288 (JP)
(72) Inventor: MATSUO Hideki, Toyooka-shi Hyogo 668-0831 (JP); NAKATA Toshinobu, Toyooka-shi Hyogo 668-0831 (JP)
(74) Representative: Hoffmann Eitle
(86) International application number: PCT/JP2015/074275
(87) International publication number: WO 2016/043014

(57) **Abstract**

Provided is a solar cell module that simultaneously suppresses reflection and light glare on the surface of a glass plate, and that has a high anti-glare function compared to conventional solar cell modules.

The solar cell module comprises: a glass plate having a macroscopically flat surface; and a photoelectric conversion element. Light passes through the glass plate and is incident on the photoelectric conversion element and the light is converted to electricity by the photoelectric conversion element. The glass plate has surface irregularities formed on a surface on an incidence side. The 60° relative specular glossiness conforming to JIS Z 8741 of a main surface of the solar cell module on the incidence side is not more than 6.5% and the maximum reflectance is not more than 0.8% when light is incident at an angle of 60° with respect to the normal of the main surface of the incidence side.

## Description

### TECHNICAL FIELD

The present invention relates to a solar cell module having an anti-glare function.

### BACKGROUND ART

Recently, a solar cell module has attracted attention as an environmentally friendly energy source.

The solar cell module is a photoelectric conversion device that can convert optical energy into electric energy.

The solar cell module is provided with a photoelectric conversion element including a transparent electrode layer, a back electrode layer, and a photoelectric conversion layer which is interposed between these two electrode layers and composed of a semiconductor junction or the like. This solar cell module is able to collect carriers (electrons and holes) generated by radiation of light to the photoelectric conversion layer by the electrode layers and extract these carriers to an external circuit.

The solar cell module is roughly classified into a crystal solar cell module and a thin-film solar cell module.

The crystal solar cell module is configured such that a plurality of the photoelectric conversion elements described above are connected with wiring lines, and is sealed using a glass plate (what is called a cover glass), a filler, and a back surface protection member such as a film or a glass plate. This crystal solar cell module can generate power by each photoelectric conversion element's receiving sunlight from the glass plate side.

On the other hand, the thin-film solar cell module is configured such that the above-mentioned photoelectric conversion element is formed on a glass plate, and sealed using a filler and a back surface protection member such as a film or a glass plate. Specifically, in the thin-film solar cell module, the glass plate is used for not only sealing but also supporting the photoelectric conversion element. This thin-film solar cell module can also generate power by each photoelectric conversion element's receiving sunlight from the glass plate side, as the crystal solar cell module.

As described above, any of the general solar cell modules have a configuration of generating power by receiving light from a glass plate.

Meanwhile, the solar cell modules described above are often installed on roofs or walls of buildings such as ordinary residences or factories.

Any of the solar cell modules described above have a configuration in which sunlight is incident on the glass plate. Therefore, if the glass plate defining the uppermost surface of the solar cell module has a mirror surface, this glass plate may serve as a mirror and reflect sunlight. For this reason, conventional solar cell modules have a problem such that "glare" or "glitter" caused by the reflection is pointed out by neighborhood residents or passing persons.

In view of this, Patent Document 1 discloses a solar cell in which an anti-glare treatment is performed by forming surface irregularities on the surface of a glass plate. The solar cell disclosed in Patent Document 1 keeps an anti-glare function by the configuration in which the glossiness of the cover glass is set to be 5 or more and 40 or less and the ten-point average roughness thereof is specified to be 50 µm or more and 300 µm or less.

### PRIOR ART DOCUMENTS

### PATENT DOCUMENTS

Patent Document 1: JP 2001-358346 A

### DISCLOSURE OF INVENTION

### TECHNICAL PROBLEM

It has generally been known that the optimum anti-glare function cannot be provided only by determining one of numerical values such as maximum reflectance and glossiness. Specifically, it is considered that whether the anti-glare function can be provided or not is determined by a plurality of intricately intertwined elements.

For example, in Patent Document 1, the glossiness of the cover glass is set to be 5 or more and 40 or less. However, the glossiness indicates a gloss caused mainly by direct reflection, and even if the glossiness assumes the numerical range described above, "glare" caused by scattering light or the like cannot always be controlled.

In addition, even if the glossiness assumes the numerical range described above, the reflection manner on an irradiated portion with light is different depending on unevenness on the irradiated portion with light. That is, light scatters due to surface irregularities on the irradiated portion with light, and therefore, the reflectance of regular reflection light does not always show the maximum value, but the reflectance of scattering light therearound may show the maximum value. Therefore, even if an amount of regular reflection light is merely reduced, sunlight may be reflected on the surface of the glass plate as an afterimage due to scattering light, by which the anti-glare function cannot be obtained.

With the above-mentioned problem in mind, the present inventors have formed surface irregularities and studied each parameter on the basis of Patent Document 1. As a result, it has been found that, when the glossiness is made small to a level same as the level in Patent Document 1, direct reflection can be suppressed as compared to an ordinary glass plate, and thus, an anti-glare function for suppressing "glare" or "glitter" can be provided to a certain extent.

On the other hand, it has also been found that the glossiness cannot be set to a value equal to or lower than a certain level in an area of the glass plate having large surface roughness as in Patent Document 1. When the surface roughness of the glass plate is increased, a scattering light component in reflection light of light is increased, resulting in that glare caused by light-reflected glare (light glare) cannot be suppressed.

As described above, a solar cell having a surface roughness equal to that of the solar cell in Patent Document 1 can suppress "glare" caused by direct reflection as compared to the conventional solar cell, but light glare may be caused on the surface of the glass as an afterimage due to scattering light. It has been found that, when such light glare occurs, "glare" or "glitter" cannot completely be eliminated, which is still likely to provide uncomfortable feeling to passing persons or the like.

In view of the foregoing problem, the present invention aims to provide a solar cell module that simultaneously suppresses reflection and light glare on the surface of a glass plate, and that has a high anti-glare function compared to conventional solar cell modules.

### SOLUTION TO PROBLEM

In view of the foregoing problem, the present inventors have formed surface irregularities having surface roughness smaller than that disclosed in Patent Document 1 to suppress a scattering light component, and examined various parameters concerning anti-glare. As a result, the present inventors have found that, mainly, two parameters are deeply involved with an anti-glare effect of a solar cell module.

One aspect of the present invention derived from the examination described above is a solar cell module including: a glass plate having a macroscopically flat surface: and a photoelectric conversion element, the solar cell module converting light to electricity by the photoelectric conversion element, the light being transmitted through the glass plate to be incident on the photoelectric conversion element, the glass plate having surface irregularities on a surface of an incidence side thereof, wherein 60° relative specular glossiness conforming to JIS Z 8741 on a main surface of an incidence side of the solar cell module is not more than 6.5%, and wherein maximum reflectance is not more than 0.8% when light is incident at an angle of 60° with respect to a normal of the main surface of the incidence side.

The "maximum reflectance" herein is a value of reflectance which is the maximum at a certain detection angle when light is incident at an angle of 60° with respect to the normal of the main surface on the incidence side and a detection angle (reflection angle) of a light-receiving side with respect to the normal is varied.

The solar cell module according to this aspect simultaneously has at least two configurations: (1) 60° relative specular glossiness, according to JIS Z 8741, of a main surface of the glass plate on the incidence side is not more than 6.5%; and (2) maximum reflectance is not more than 0.8% when light is incident at an angle of 60° with respect to the normal of the main surface of the glass plate on the incidence side.

When simultaneously achieving these configurations, the solar cell module can suppress reflection of light (sunlight) as well as light glare on the surface of the glass plate, and can provide a higher anti-glare function than conventional solar cell modules.

If the 60° relative specular glossiness, according to JIS Z 8741, of the main surface of the glass plate on the incidence side exceeds 6.5%, or maximum reflectance exceeds 0.8% when light is incident at an angle of 60° with respect to the normal of the main surface of the glass plate on the incidence side, direct reflection can be suppressed, but "glare" may occur due to the light glare caused by regular reflection light or scattering light, or conversely, the light glare caused by regular reflection light or scattering light can be prevented, but "glare" due to direct reflection may occur. Therefore, in such cases, it is likely that an excellent anti-glare function cannot be provided.

Preferably, the 60° relative specular glossiness conforming to JIS Z 8741 on the main surface of the incidence side is not more than 4.1 %.

Preferably, the maximum reflectance is not more than 0.45% when light is incident at an angle of 60° with respect to the normal of the main surface of the incidence side.

Preferably, R60/R45 is not more than 2.7, the R60 being defined as reflectance at a reflection angle of 60° with respect to the normal of the main surface of the incidence side when light is incident at an angle of 60° with respect to the normal, the R45 being defined as reflectance at a reflection angle of 45° with respect to the normal of the main surface of the incidence side when light is incident at an angle of 60° with respect to the normal.

The solar cell module according to the aspect described above further has the configuration (3) in which R60/R45 is not more than 2.7, in addition to at least the above-mentioned configurations (1) and (2). Specifically, the scattering light component of reflection light assumes a value close to the value of the regular reflection component, whereby light is evenly dispersed, and a high anti-glare function is provided.

More preferably, the R60/R45 is not more than 2.0.

Preferably, arithmetic mean roughness on the surface of the incidence side of the glass plate is 0.25 µm or more and 1.25 µm or less.

Within this range, "glare" or "glitter" can be more effectively prevented.

When the arithmetic mean roughness of the glass plate is less than 0.25 µm, the height difference of irregularities is too small to suppress reflection in some cases. Specifically, a light dispersion effect cannot sufficiently be exhibited, so that the component of regular reflection light may become too large.

In addition, when the arithmetic mean roughness of the glass plate exceeds 1.25 µm, the height difference of irregularities becomes too large, and therefore, light is undesirably irregularly reflected on the side face of a projection or a recess of irregularities, which leads to an increase in a scattering light component. Therefore, light glare is generated, resulting in that "glare" or "glitter" may occur.

More preferably, the arithmetic mean roughness on the surface of the incidence side of the glass plate is 0.4 µm or more and 0.9 µm or less, and standard deviation thereof is 0.015 to 0.02.

According to this configuration, irregularities having substantially uniform roughness are formed, whereby a uniform anti-glare effect is easy to be obtained.

Preferably, a half width to the maximum peak is not less than 22° when reflectance with respect to each reflection angle to light is graphically shown, the light being incident at an angle of 60° with respect to the normal of the main surface of the incidence side.

The "half width" herein indicates the width ΔX (width of the reflection angle) on a point having a value half of the peak height ΔY (difference between the maximum point and the minimum point) at the peak top of a prescribed waveform on X-Y plane.

According to this configuration, a low and broad peak is obtained with at least the maximum reflectance being not more than 0.8% and the half width of the maximum peak being not less than 22°.

Within this range, the reflection and light glare of sunlight can be suppressed, at whatever angle the glass plate, which is the incidence surface of the solar cell module, is viewed, whereby a high anti-glare effect can be provided.

When the half width of the maximum peak is less than 22°, a sharp peak is formed, and therefore, "glare" or "glitter" may occur depending on an angle at which the incidence surface is viewed.

More preferably, the half width to the maximum peak is not less than 29°.

Preferably, the glass plate supports the photoelectric conversion element including two electrode layers and a photoelectric conversion layer interposed between the two electrode layers, one of the two electrode layer being a transparent conductive film and facing the glass plate.

Preferably, an antireflection film is provided on the surface of the incidence side of the glass plate, and refractive index of the antireflection film with respect to light having a wavelength of 600 nm is larger than 1 and not more than refractive index of the glass plate.

According to this configuration, light passing through the glass plate and incident on the photoelectric conversion element is difficult to exit from the glass plate side, and thus, light is easy to stay on the photoelectric conversion element side. Therefore, a solar cell module having high photoelectric conversion efficiency can be provided.

One aspect of the present invention is a solar cell module including: a glass plate having a macroscopically flat surface: and a photoelectric conversion element, the solar cell module converting light to electricity by the photoelectric conversion element, the light being transmitted through the glass plate to be incident on the photoelectric conversion element, the glass plate having surface irregularities on a surface of an incidence side thereof, wherein arithmetic mean roughness of the glass plate is 0.25 µm or more and 1.25 µm or less, wherein 60° relative specular glossiness conforming to JIS Z 8741 on a main surface of an incidence side of the solar cell module is not more than 4.1 %, wherein maximum reflectance is not more than 0.45% when light is incident at an angle of 60° with respect to a normal of the main surface of the incidence side, and wherein R60/R45 is not more than 2.0, the R60 being defined as reflectance at a reflection angle of 60° with respect to the normal of the main surface of the incidence side when light is incident at an angle of 60° with respect to the normal, the R45 being defined as reflectance at a reflection angle of 45° with respect to the normal of the main surface of the incidence side when light is incident at an angle of 60° with respect to the normal.

According to this aspect, a solar cell module having a high anti-glare function can be provided.

### EFFECT OF INVENTION

The solar cell module according to the present invention can provide a high anti-glare function.

### BRIEF DESCRIPTION OF DRAWINGS

Fig. 1 is a perspective view schematically illustrating an installment state of a solar cell module according to a first embodiment of the present invention.
Fig. 2 is a sectional view schematically illustrating the solar cell module illustrated in Fig. 1.
Figs. 3A to 3C illustrate explanatory views for illustrating a manufacturing process of the solar cell module according to the first embodiment, wherein Fig. 3A is a sectional view illustrating that a transparent electrode layer is divided, Fig. 3B is a sectional view illustrating that a photoelectric conversion layer is divided, and Fig. 3C is a sectional view illustrating that the photoelectric conversion layer and a back electrode layer are segmented.
Figs. 4A to 4D illustrate explanatory views for illustrating a manufacturing process of the solar cell module according to the first embodiment, wherein Fig. 4A is a sectional view of a substrate after a photoelectric conversion element forming process is completed, Fig. 4B is a sectional view of the substrate after a first irregularity forming process is completed, Fig. 4C is a sectional view of the substrate after a second irregularity forming process is completed, and Fig. 4D is a sectional view of the substrate after an antireflection film forming process is completed.
Fig. 5 is an explanatory view briefly illustrating a reflectance measurement method in which an incidence angle is fixed and a detection angle is varied.
Fig. 6 is an explanatory diagram showing one example of reflectance of the solar cell module according to the first embodiment of the present invention relative to detection angle.
Fig. 7 is an explanatory view briefly illustrating a reflectance measurement method in which an incidence angle and a detection angle are the same.
Fig. 8 is a graph showing reflectances of regular reflection light with respect to each incidence angle for tiles in Comparative Examples 1 to 3 and a solar cell module in Example 1.
Fig. 9 is a graph showing reflectances of light at each moving angle when irregular surfaces of glass substrates of solar cell modules in Comparative Examples 4 and 5 and Example 1 are irradiated with light at an incidence angle of 60°.
Figs. 10A to 10C illustrate photographs for observing the states of solar cell modules in Comparative Examples 4 and 5 and Example 1 illustrated in Fig. 9, which are irradiated with light, wherein Fig. 10A illustrates the solar cell module in Comparative Example 4, Fig. 10B illustrates the solar cell module in Comparative Example 5, and Fig. 10C illustrates the solar cell module in Example 1.
Fig. 11 is a graph illustrating glossiness with respect to surface roughness when the irregular surface of the glass substrate of the solar cell module is irradiated with light at an incidence angle of 60°, wherein the border between Comparative Example 6 and Example 2 and the border between Example 2 and Comparative Example 7 are indicated by a broken line.
Figs. 12A to 12C illustrate photographs for observing the states of solar cell modules in Comparative Examples 6 and 7 and Example 2 illustrated in Fig. 11, which are irradiated with light, wherein Fig. 12A illustrates the solar cell module in Comparative Example 6, Fig. 12B illustrates the solar cell module in Example 2, and Fig. 12C illustrates the solar cell module in Comparative Example 7.
Fig. 13 is a graph showing reflectances of light at each moving angle when solar cell modules in Comparative Examples 6 and 7 and Examples 2-1 and 2-2 are irradiated with light at an incidence angle of 60°.
Fig. 14 is an explanatory view illustrating the relationship between the glossiness and the maximum reflectance of the solar cell modules in Comparative Examples 6 and 7 and Examples 2-1 and 2-2 and tiles in Reference Examples 1-1 and 1-2, wherein those not generating light glare are encircled by a line.
Fig. 15 is an explanatory view illustrating the relationship between the maximum reflectance and the peak half-width of the solar cell modules in Comparative Examples 6 and 7 and Examples 2-1 and 2-2 and tiles in Reference Examples 1-1 and 1-2, wherein those not generating light glare are encircled by a line.
Fig. 16 is an explanatory view illustrating the relationship between the glossiness and the peak half-width of the solar cell modules in Comparative Examples 6 and 7 and Examples 2-1 and 2-2 and tiles in Reference Examples 1-1 and 1-2, wherein those not generating light glare are encircled by a line.
Fig. 17 is a perspective view illustrating the condition for evaluating glare in the solar cell modules in Example 1 and Comparative Example 4.
Fig. 18 is a side view illustrating the condition for evaluating glare in the solar cell modules in Example 1 and Comparative Example 4.
Figs. 19A to 19C illustrate one example of the glare evaluation of the solar cell module in Comparative Example 4, wherein Fig. 19A is a photograph of the surface of the solar cell module in Comparative Example 4, Fig. 19B is a graph showing luminance at each of measurement points on a white line in Fig. 19A, and Fig. 19C is a graph obtained by enlarging the scale of the graph in Fig. 19B.
Figs. 20A to 20C illustrate one example of the glare evaluation of the solar cell module in Example 1, wherein Fig. 20A is a photograph of the surface of the solar cell module in Example 1, Fig. 20B is a graph showing luminance at each of measurement points on a white line in Fig. 20A, and Fig. 20C is a graph obtained by enlarging the scale of the graph in Fig. 20B.

### BEST MODE FOR CARRYING OUT THE INVENTION

Embodiments of the present invention will be described in detail below.

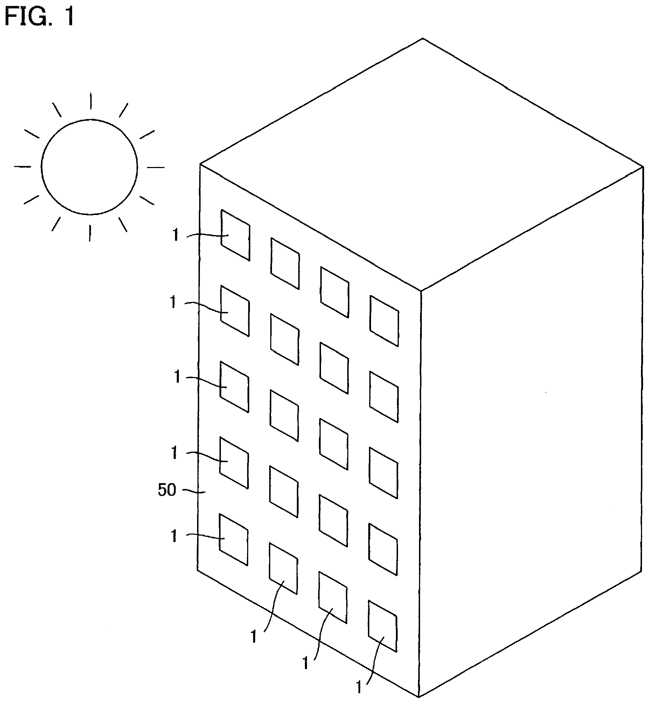

Note that, in the description below, the vertical positional relation of a solar cell module 1 will be described based on the orientation in Fig. 1, unless otherwise specified.

The solar cell module 1 according to a first embodiment is a wall mounted solar cell module which is mounted on a wall surface of a building such as an office building as illustrated in Fig. 1. Specifically, the solar cell module 1 is a wall surface forming member that is mounted on a wall 50 of a building to form a part of the outer wall surface of the building.

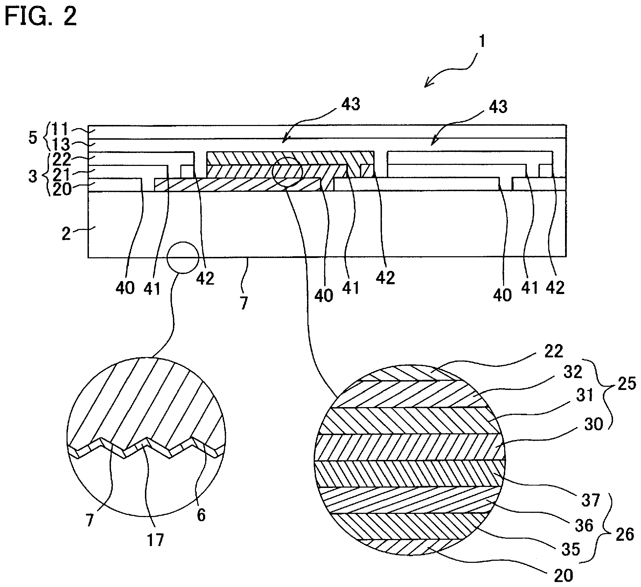

As illustrated in Fig. 2, the solar cell module 1 is a thin-film solar cell module including a glass substrate 2 (glass plate) as a support substrate. The solar cell module 1 is configured such that a photoelectric conversion element 3 including a plurality of thin films is interposed between the glass substrate 2 and a sealing member 5. The solar cell module 1 is configured such that a plurality of small pieces of the photoelectric conversion element 3 is connected in series or in parallel to form a module.

As illustrated in Fig. 2, the solar cell module 1 has the glass substrate 2, the photoelectric conversion element 3, and the sealing member 5, which are layered in this order from a light incidence side.

In the solar cell module 1 according to the present embodiment, an anti-glare treatment is performed on the surface of the glass substrate 2, and the surface shape of the glass substrate 2 or the like is one of the features of the solar cell module 1.

The glass substrate 2 is a planar glass plate member, and is a translucent insulating substrate that does not electrically contribute to power generation.

The glass substrate 2 is not particularly limited, so long as it is a glass plate having translucency. However, a white plate glass is preferable in the light of being inexpensive and having high transmittance in an absorption wavelength range of the solar cell module.

A white plate glass is used for the glass substrate 2 in the present embodiment.

In addition, the glass substrate 2 is subjected to an anti-glare treatment on at least one main surface. Specifically, although the glass substrate 2 is macroscopically flat, surface irregularities 6 are microscopically formed on one main surface as illustrated in the enlarged view of Fig. 2.

The arithmetic mean roughness of the main surface (hereinafter also referred to as an irregular surface 7) of the glass substrate 2 provided with the surface irregularities 6 is preferably not less than 0.25 µm, and more preferably not less than 0.4 µm, from the viewpoint of suppressing regular reflection of light.

The arithmetic mean roughness of the irregular surface 7 of the glass substrate 2 is preferably not more than 1.25 µm, and more preferably not more than 0.9 µm, from the viewpoint of suppressing an amount of scattering light by light dispersion.

The arithmetic mean roughness of the irregular surface 7 of the glass substrate 2 according to the present embodiment is 0.4 µm or more and 0.9 µm or less, by which more light scattering is enabled to implement reduction in amounts of both regular reflection light and scattering light. Accordingly, this configuration can prevent glare caused by the regular reflection of sunlight and glare caused by the reflection of sunlight.

In addition, the standard deviation of the roughness of the surface irregularities 6 on the irregular surface 7 of the glass substrate 2 is preferably 0.015 to 0.02. The standard deviation of the roughness of the surface irregularities 6 on the irregular surface 7 of the glass substrate 2 according to the present embodiment is 0.017. This indicates that the surface irregularities 6 on the irregular surface 7 are substantially uniformly distributed.

On the other hand, the inner main surface (the surface opposite to the irregular surface 7) of the glass substrate 2 according to the present embodiment is macroscopically smooth and flat.

The mean thickness of the glass substrate 2 is preferably 3.0 mm or more and 5.0 mm or less, although it is appropriately designed on the basis of the rigidity to a protection sheet 11, an installment environment, or the like. If the mean thickness is within this range, the solar cell module 1 can provide sufficient strength when being used as a wall surface.

In addition, the refractive index of the glass substrate 2 is preferably 1.50 or more and 1.60 or less. If the refractive index is within this range, light is difficult to be reflected, and most of light can be transmitted toward the photoelectric conversion element 3.

Preferable methods for forming the surface irregularities 6 on the glass substrate 2 include spraying sandblast, immersing the glass substrate 2 into etching solution, and scattering microparticles. Among these methods, the method using sandblast is preferable as described later.

An antireflection film 17 is formed on the surface of the glass substrate 2.

The antireflection film 17 is a film for suppressing reflection of light, and specifically, has a refractive index between the refractive index (approximately 1) of air and the refractive index of the glass substrate 2. Specifically, the refractive index of the antireflection film 17 with respect to light with a wavelength of 600 nm is larger than 1 and not more than the refractive index of the glass substrate 2. Preferably, the refractive index of the antireflection film 17 with respect to light with a wavelength of 600 nm is 1.35 to 1.60.

Preferably, the antireflection film 17 is formed from a substance containing fine particles made of titanium oxide and silicon oxide. That is, the antireflection film 17 includes titanium oxide fine particles and silicon oxide fine particles.

The photoelectric conversion element 3 is a semiconductor element that extracts optical energy as electric energy, and includes a photoelectric conversion layer 21 interposed between two electrode layers 20 and 22 as illustrated in Fig. 2. Specifically, the photoelectric conversion element 3 is configured such that the transparent electrode layer 20, the photoelectric conversion layer 21, and the back electrode layer 22 are layered in this order from the side of the glass substrate 2.

The transparent electrode layer 20 is a transparent conductive film and has translucency and conductivity.

The material for forming the transparent electrode layer 20 is not particularly limited, so long as it has translucency and conductivity. For example, the transparent electrode layer 20 is formed of transparent conductive oxide such as indium tin oxide (ITO), indium zinc oxide (IZO), tin oxide (SnO₂) or zinc oxide (ZnO).

Note that the transparent electrode layer 20 may be formed by adding a doping agent into the transparent conductive oxides described above.

The photoelectric conversion layer 21 has a function of converting optical energy into electric energy, and is a semiconductor layer having at least a PIN structure or a PN structure.

The photoelectric conversion layer 21 is composed of one or more photoelectric conversion units.

As illustrated in the enlarged view in Fig. 2, the photoelectric conversion layer 21 in the present embodiment has a tandem structure in which a crystalline photoelectric conversion unit 25 composed mainly of crystalline silicon layers and an amorphous photoelectric conversion unit 26 composed mainly of amorphous silicon layers are connected to each other.

In the photoelectric conversion layer 21, both photoelectric conversion units 25 and 26 have a PIN junction.

The "crystalline" herein indicates other than amorphous. That is, it is a concept including microcrystal and polycrystal.

The photoelectric conversion layer 21 is configured such that the amorphous photoelectric conversion unit 26 and the crystalline photoelectric conversion unit 25 are layered in this order from the side of the transparent electrode layer 20.

As illustrated in the enlarged view in Fig. 2, the crystalline photoelectric conversion unit 25 is configured such that a p-type crystalline silicon semiconductor layer 30, an i-type crystalline silicon semiconductor layer 31, and an n-type crystalline silicon semiconductor layer 32 are layered in this order from the side of the transparent electrode layer 20 (the side of the amorphous photoelectric conversion unit 26).

The amorphous photoelectric conversion unit 26 is configured such that a p-type amorphous silicon semiconductor layer 35, an i-type amorphous silicon semiconductor layer 36, and an n-type amorphous silicon semiconductor layer 37 are layered in this order from the side of the transparent electrode layer 20.

The back electrode layer 22 is composed of a metal thin film, a transparent conductive oxide thin film, or a laminate body of these films. For example, a thin film formed of aluminum, copper, molybdenum, silver, or the like can be used for the metal thin film. For example, indium tin oxide (ITO), tin oxide (SnO₂) zinc oxide (ZnO), or the like can be used for the transparent conductive oxide thin film.

The sealing member 5 has a multi-layer structure in which a sealing sheet 13 and a protection sheet 11 are layered in this order from the side of the back electrode layer 22.

As illustrated in Fig. 2, the sealing sheet 13 is a member for sealing the photoelectric conversion element 3 and for easing pressing force from the protection sheet 11.

Examples of materials that can be used for the sealing sheet 13 include EVA (ethylene-vinyl acetate copolymer), PVB, ionomer of ethylene-unsaturated carboxylic acid copolymer, and thermoplastic elastomer, and a mixture of these materials.

The protection sheet 11 is a member defining the outermost surface of the solar cell module 1 and protecting the photoelectric conversion element 3 from external shock or the like.

Examples of materials that can be used for the protection sheet 11 include a lamination film such as PET/aluminum/PVF or PET/aluminum/PET, and a glass plate.

Subsequently, a manufacturing method of the solar cell module 1 according to the first embodiment will be described.

The solar cell module 1 according to the first embodiment is manufactured mainly by two processes.

Specifically, the solar cell module 1 is manufactured by a photoelectric conversion element forming process and a surface treatment process.

The photoelectric conversion element forming process is substantially the same as a manufacturing process of a known solar cell module, so that it will briefly be described.

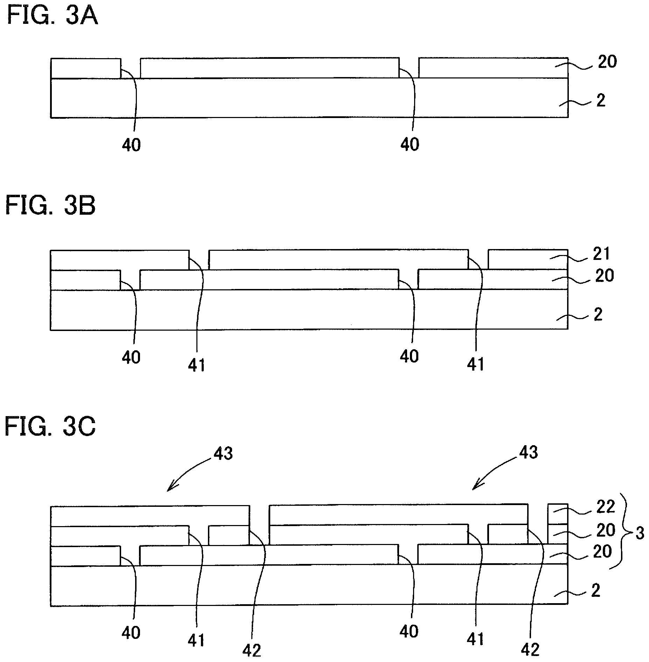

In the photoelectric conversion element forming process, the transparent electrode layer 20 is firstly formed on the back surface (the surface opposite to the light incidence surface) of the glass substrate 2 by a thermal CVD method, as illustrated in Fig. 3A. Then, transparent electrode separation grooves 40 for dividing the formed transparent electrode layer 20 into a plurality of small pieces are formed by using a laser scribing machine, as needed (transparent electrode layer forming process).

Next, this transparent electrode layer 20 is placed in a high-frequency plasma CVD device, and then, the p-type amorphous silicon semiconductor layer 35, the i-type amorphous silicon semiconductor layer 36, the n-type amorphous silicon semiconductor layer 37, and the like are sequentially layered on the transparent electrode layer 20 to form the amorphous photoelectric conversion unit 26.

Thereafter, the p-type crystalline silicon semiconductor layer 30, the i-type crystalline silicon semiconductor layer 31, the n-type crystalline silicon semiconductor layer 32, and the like are sequentially layered on the amorphous photoelectric conversion unit 26 to form the crystalline photoelectric conversion unit 25 by continuously using the plasma CVD device. Thus, the photoelectric conversion layer 21 is formed. Then, as illustrated in Fig. 3B, electrode connection grooves 41 for dividing the photoelectric conversion layer 21 thus formed into a plurality of small pieces are formed on the photoelectric conversion layer 21 by using a laser scribing machine, as needed (photoelectric conversion layer forming process).

Then, as illustrated in Fig. 3C, the back electrode layer 22 is formed on the photoelectric conversion layer 21 by using a sputtering device. Back electrode separation grooves 42 for dividing the photoelectric conversion layer 21 and the back electrode layer 22 are formed by using a laser scribing machine, when needed (back electrode layer forming process). In this case, the photoelectric conversion element 3 formed by the above-mentioned process is divided into a plurality of photoelectric conversion cells 43 by the transparent electrode separation grooves 40 and the back electrode separation grooves 42. The photoelectric conversion cells 43 and 43 adjacent to each other are electrically connected to each other in such a way that the back electrode layer 22 of one photoelectric conversion cell 43 enters the electrode connection groove 41 to be in contact with the transparent electrode layer 20 of the other photoelectric conversion cell 43.

Then, the photoelectric conversion element 3 formed by the above-mentioned process is sealed by the sealing member 5 composed of the sealing sheet 13 and the protection sheet 11, and thus, the photoelectric conversion element forming process is completed.

Next, the surface treatment process for performing the surface treatment on the light incidence surface of the glass substrate 2 is executed.

The surface treatment process is mainly classified into an irregularity forming process and an antireflection film forming process.

In the irregularity forming process, the surface irregularities 6 are formed on the light incidence surface of the glass substrate 2 by more than one irregularity forming processes.

In the irregularity forming process in the present embodiment, the surface irregularities 6 are formed on the light incidence surface of the glass substrate 2 by a first irregularity forming process and a second irregularity forming process.

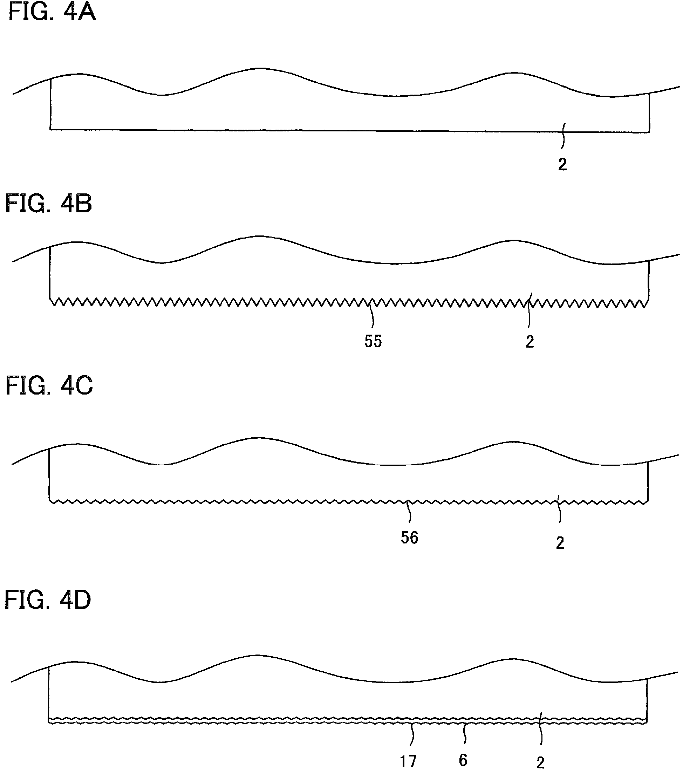

Specifically, as understood from Figs. 4A and 4B, the surface of the glass substrate 2 is treated by blasting using a polishing material to form relatively rough surface irregularities 55 thereon in the first irregularity forming process.

Then, as understood from Figs. 4B and 4C, in the second irregularity forming process, the glass substrate 2, on which the relatively rough surface irregularities are formed, is polished by blasting using a polishing material having abrasive grains smaller in diameter than those in the polishing material used in the first irregularity forming process, by which the surface irregularities 55 are converted into fine surface irregularities 56.

In this case, sandblasting using a polishing material is employed in the blasting in each of these processes.

White alumina is preferably usable as the polishing material used in the first irregularity forming process. It is preferable that the polishing material used in the first irregularity forming process has a number count within the range of #40 to #600.

In addition, white alumina is preferably usable as the polishing material used in the second irregularity forming process. It is preferable that the polishing material used in the second irregularity forming process has a number count which is larger than that of the polishing material used in the first irregularity forming process and within the range of #400 to #3000.

This is the irregularity forming process.

Next, the substrate on which the surface irregularities are formed by the irregularity forming process is treated by the antireflection film forming process.

In this antireflection film forming process, a liquid raw material of the antireflection film 17 is applied on the irregular surface by spraying or the like, and then, solidified to form the antireflection film 17.

In the present embodiment, a water-soluble titanium silicon coating agent containing fine particles made of titanium oxide and silicon oxide is applied on the irregular surface by spraying or the like, and air-dried to form the antireflection film 17.

The main manufacturing process of the solar cell module 1 is ended at the time of the completion of the antireflection film forming process.

Subsequently, the physical properties of the solar cell module 1 obtained by the manufacturing process described above will be described. Notably, the physical properties described herein are obtained from the results of a large number of experiments, and an error bar and an empirical approach are also considered therefor. Accordingly, the physical properties described herein may assume numerical values slightly different from the measured values in later-described Examples of the present invention.

On the main surface of the solar cell module 1 on the side of the glass substrate 2, the 60° relative specular glossiness, according to JIS Z 8741, of the irregular surface 7 is not more than 6.5%, when light is radiated at an angle of 60° with respect to the normal of the irregular surface 7 of the glass substrate 2 forming the main surface on the incidence side. The 60° relative specular glossiness of the irregular surface 7 is preferably not more than 4.1 % from the viewpoint of achieving more excellent anti-glare effect.

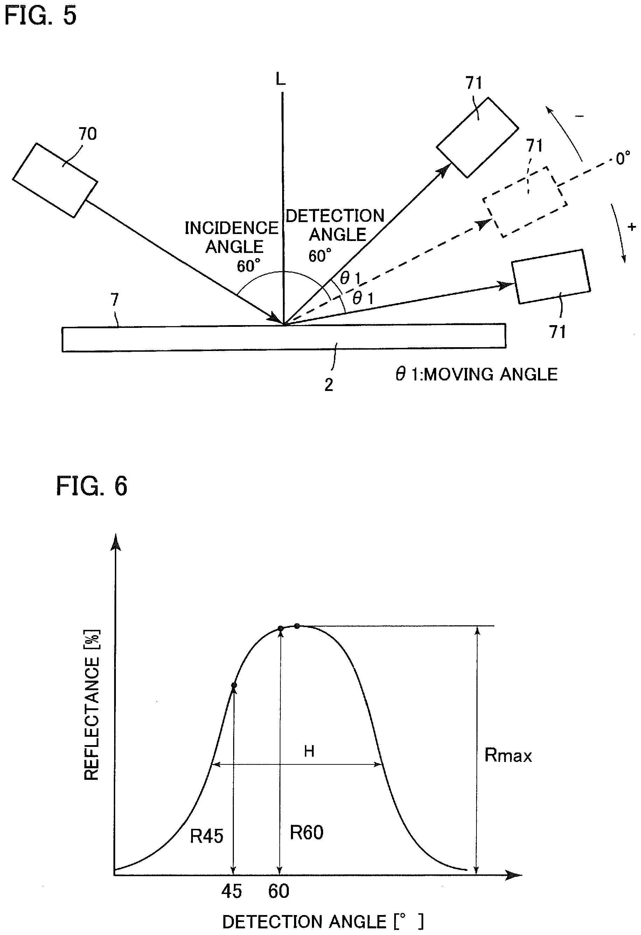

In addition, the maximum reflectance and the like measured according to the measurement method illustrated in Fig. 5 are also one of the features of the glass substrate 2 of the solar cell module 1 according to the present embodiment.

Firstly, the measurement method illustrated in Fig. 5 will be described. A light source 70 is installed such that light is incident on the irregular surface 7 to be measured of the glass substrate 2 at an incidence angle of 60°. On the other hand, a detector 71 having a light-receiving element is placed on the light reflection side.

Then, light with a wavelength of 550 nm is emitted from the light source 70 at an incidence angle of 60° with respect to the normal L of the irregular surface 7, and with this state, the detection angle (reflection angle) of the light-receiving element of the detector 71 with respect to the normal L is continuously changed to continuously measure the reflectance at each detection angle (each reflection angle).

Here, the position at the regular reflection angle of 60° with respect to the incidence angle of 60° is defined as a reference (0°), and a moving angle from this position is indicated as θ1. The moving angle is set to be negative (-θ1) when the detection angle (reflection angle) is smaller than 60° and to be positive (+θ1) when the detection angle (reflection angle) is larger than 60°. Specifically, the moving angle θ1 assumes a value obtained by subtracting 60° from the detection angle (reflection angle).

The reflectances, on the main surface of the solar cell module 1 on the side of the glass substrate 2, relative to each detection angle (reflection angle) which is measured in accordance with the above-mentioned measurement method when light is incident at an angle of 60° with respect to the normal L of the irregular surface 7 are schematically graphically illustrated in Fig. 6.

The maximum reflectance Rmax of the main surface of the solar cell module 1 on the side of the glass substrate 2 illustrated in Fig. 6 is not more than 0.8% when light is incident at an angle of 60° with respect to the normal L of the irregular surface 7. This maximum reflectance Rmax is preferably not more than 0.65%, and more preferably not more than 0.45% from the viewpoint of providing more excellent anti-glare effect.

In addition, the maximum reflectance Rmax of the main surface of the solar cell module 1 on the side of the glass substrate 2 is more preferably not more than 0.40%, and much more preferably not more than 0.38%, from the viewpoint of suppressing amounts of regular reflection light and scattering light.

When the reflectances relative to each detection angle (reflection angle) when light is incident at an angle of 60° with respect to the normal L of the irregular surface 7 on the main surface of the glass substrate 2 of the solar cell module 1 are graphically illustrated as in Fig. 6, the half width H of the maximum peak is preferably not less than 22°, and more preferably not less than 29°.

The half width H of the maximum peak on the main surface of the solar cell module 1 on the side of the glass substrate 2 is more preferably not less than 30° from the viewpoint of uniformly suppressing reflection when the glass substrate 2 is viewed.

In the solar cell module 1, R60/R45 is preferably not more than 2.7, more preferably not more than 2.0, and much more preferably not more than 1.5, wherein when light is incident at an angle of 60° with respect to the normal L of the irregular surface 7, the reflectance at the detection angle (reflection angle) of 60° with respect to the normal L is defined as R60 , and the reflectance at the detection angle (reflection angle) of with respect to the normal L is defined as R45, as illustrated in Fig. 6.

In addition, R60/R45 is preferably not less than 1, and more preferably not less than 1.2.

The solar cell module 1 according to the present embodiment is subjected to the anti-glare treatment on the glass substrate 2, thereby being capable of preventing the occurrence of glare or glitter caused by the reflection of sunlight on the surface of the glass substrate 2.

In addition, the solar cell module 1 according to the present embodiment defines a wall surface.

When a conventional solar cell module is mounted on a wall surface on the lower part of a building structure, a passing person is reflected into a glass substrate of the solar cell module due to the mirror surface of the glass substrate, and this is likely to provide uncomfortable feeling to the passing person.

On the other hand, the solar cell module 1 according to the present embodiment is subjected to the anti-glare treatment on the glass substrate 2, thereby being capable of preventing a passing person from being reflected therein and having uncomfortable feeling.

In the embodiment described above, the surface irregularities 6 are formed on only one surface of the glass substrate 2. However, the present invention is not limited thereto, and the surface irregularities 6 may be formed on both surfaces.

In the embodiment described above, the surface irregularities 6 are formed on the light incidence surface of the glass substrate 2. However, the present invention is not limited thereto, and the surface irregularities 6 may be formed on the surface facing the photoelectric conversion element 3.

In the embodiment described above, the solar cell module 1 is used as a part of the wall surface of a building structure such as an office building. However, the present invention is not limited thereto, and may be used for a part of a handrail of a veranda, balcony, or the like. In addition, the solar cell module 1 may be used as a part of a roof member of a building, such as a tile, or may be installed on a roof of a building, on a ground, or the like.

The above-mentioned embodiment describes what is called a thin-film solar cell module. However, the present invention is not limited thereto, and may be applied to other solar cell modules. For example, a crystal solar cell module may be employed. In this case, the present invention is well applicable, so long as the solar cell module has a glass (cover glass) on a light incidence surface.

The present invention will be described below in more detail with reference to Examples, but the present invention is not limited to these Examples.

### [Examples]

The manufacturing procedures and evaluation results of specific Examples according to the present invention and Comparative Examples with respect to Examples will be described.

### (Example 1)

A solar cell module 1 in Example 1 was manufactured by a photoelectric conversion element forming process and a surface treatment process described below.

In the photoelectric conversion element forming process, a transparent electrode layer 20 (tin oxide) was formed on a glass substrate 2 (white plate glass) by a thermal CVD method, and the formed transparent electrode layer 20 was divided into a plurality of small pieces by a laser scribing machine.

Next, this substrate was placed in a high-frequency plasma CVD device, and then, a p-type amorphous silicon carbide layer, an i-type amorphous silicon buffer layer, an i-type amorphous silicon conversion layer, and an n-type silicon oxide layer were sequentially layered on the transparent electrode layer 20 to form an amorphous photoelectric conversion unit 26.

Thereafter, a p-type thin-film crystalline silicon layer, an i-type crystalline silicon conversion layer, an n-type silicon oxide layer, and an n-type thin-film crystalline silicon layer were sequentially layered on the amorphous photoelectric conversion unit 26 to form a crystalline photoelectric conversion unit 25. Thus, a photoelectric conversion layer 21 was formed.

The photoelectric conversion layer 21 thus formed was divided into a plurality of small pieces by a laser scribing machine.

Then, a thin film of zinc oxide and a thin film of silver were sequentially layered on the photoelectric conversion layer 21 as a back electrode layer 22 by a sputtering device, and the formed back electrode layer 22 was divided by a laser scribing machine.

According to these processes, the solar cell module 1 in Example 1 was configured such that the photoelectric conversion element 3 was divided into a plurality of small pieces, and these small pieces were electrically connected to one another in series.

The photoelectric conversion element 3 formed by the above-mentioned processes was sealed by a sealing sheet 13 and a protection sheet 11, and thus, the photoelectric conversion element forming process was completed.

In this case, an EVA sheet which is a resin sheet was used as the sealing sheet, and a PET/aluminum/PVF was used as the protection sheet.

Subsequently, the surface treatment process was performed, that is, the irregularity forming process and the antireflection film forming process were performed.

In the irregularity forming process, sandblasting was employed in both the first irregularity forming process and the second irregularity forming process, and then, the irregular surface of the glass substrate 2 was washed by tap water.

Then, in the antireflection film forming process, a water-soluble titanium silicon coating agent containing fine particles made of titanium oxide and silicon oxide was applied by spraying, and air-dried to form an antireflection film 17. In this antireflection film forming process, a hydrophilic treatment using a hydrophilic treatment agent or the like was not performed.

The solar cell module 1 having the surface irregularities 6 as described above was defined as Example 1.

### (Comparative Example 1)

A ceramic tile was used as Comparative Example 1.

### (Comparative Example 2)

A decorative slate tile was used as Comparative Example 2.

### (Comparative Example 3)

A metal tile was used as Comparative Example 3.

Regular reflectance with respect to each incidence angle was measured for the solar cell module of Example 1, the ceramic tile of Comparative Example 1, the decorative slate of Comparative Example 2, and the metal tile of Comparative Example 3 by synchronized measurement using a goniophotometer. For the measurement of regular reflectance, the goniophotometer (made by UV-VIS-NIR spectrophotometer V-670 and automated absolute reflectance measurement accessory ARMN-735) manufactured by JASCO Corporation was used. In addition, the measurement condition was set such that the wavelength of incident light was 550 nm, and the incidence angle and detection angle (reflection angle) was set to be within the range from 30° to 70°.

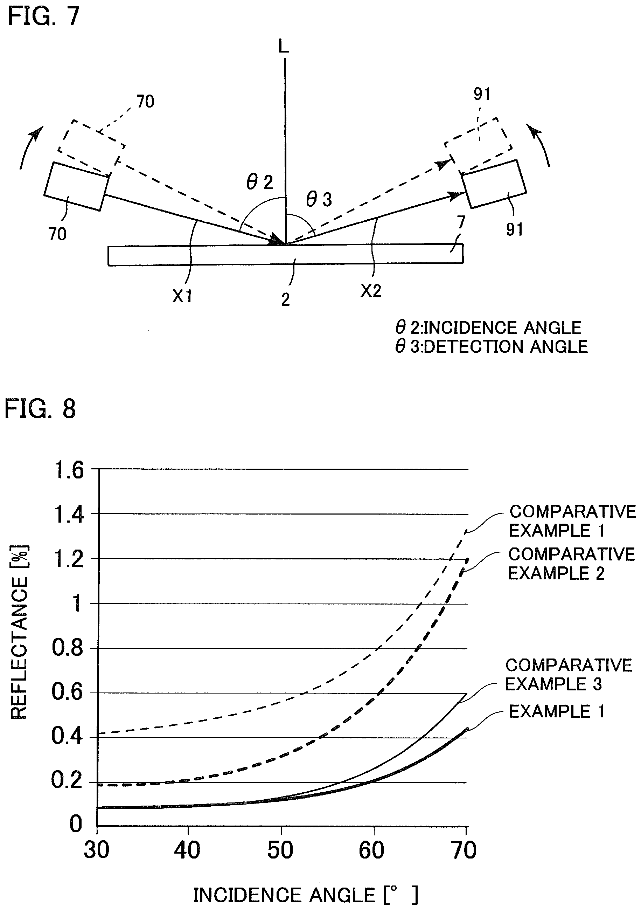

Describing this measurement method in detail, a light source 70 and a detector 91 are set on symmetrical positions with respect to the normal of the irregular surface 7 of the glass substrate 2 as illustrated in Fig. 7. Specifically, the light source 70 and the detector 91 are set such that the angle (incidence angle θ2) of an optical axis X1 of the light source 70 and the angle (detection angle (reflection angle) θ3) of an optical axis X2 of the detector 91 are the same.

Then, light with a wavelength of 550 nm is emitted to the irregular surface 7 from the light source 70, and the positions of the light source 70 and the detector 91 are continuously changed such that the angle θ2 of the optical axis X1 of the light source 70 and the angle θ3 of the optical axis X2 of the detector 91 are always the same, to continuously measure regular reflectance at each incidence angle with respect to the normal. The measurement results are shown in Fig. 8.

As shown in Fig. 8, reflectance was small at any incidence angle of Example 1, compared to the tiles of Comparative Examples 1 to 3. Specifically, it is found that, in the solar cell module of Example 1, the amount of light of regular reflection is small at whatever angle light is emitted, compared to the tiles in Comparative Examples 1 to 3, and thus, glare by regular reflection light can be prevented.

The regular reflectance of the ceramic tile in Comparative Example 1 was about 0.8% at the incidence angle θ2 of 60°. The regular reflectance of the decorative slate tile in Comparative Example 2 was about 0.6% at the incidence angle θ2 of 60°. The regular reflectance of the metal tile in Comparative Example 3 was about 0.28% at the incidence angle θ2 of 60°. On the other hand, the regular reflectance of the solar cell module 1 in Example 1 was about 0.21 % at the incidence angle θ2 of 60°.

### (Afterimage and optical evaluation)

For afterimage evaluation and optical evaluation, the solar cell module in Example 1 and solar cell modules in Comparative Examples 4 and 5 were manufactured and evaluated.

### (Comparative Example 4)

The solar cell module of Comparative Example 4 was manufactured similarly to Example 1 except that the anti-glare treatment was not performed. That is, the solar cell module of Comparative Example 4 was not subjected to the surface treatment process.

### (Comparative Example 5)

In the solar cell module in Comparative Example 5, the surface irregularities 6 were formed by using white alumina abrasive grains of which are larger than those in Example 1. Apart from that, it was manufactured similarly to Example 1.

Reflectance was measured for the solar cell module of Example 1, the solar cell module of Comparative Example 4, and the solar cell module of Comparative Example 5 by using the device same as described above. In addition, the measurement condition was set such that the wavelength of incident light was 550 nm, the incidence angle was fixed to 60°, the position of the regular reflection angle of 60° with respect to the incidence angle of 60° was defined as a reference (0°), and the moving angle θ1 from this position was set to be within the range from -40° to 10°.

In addition, the solar cell module of Example 1, the solar cell module of Comparative Example 4, and the solar cell module of Comparative Example 5 were irradiated with light from the normal direction, and the surfaces thereof were photographed by a camera.

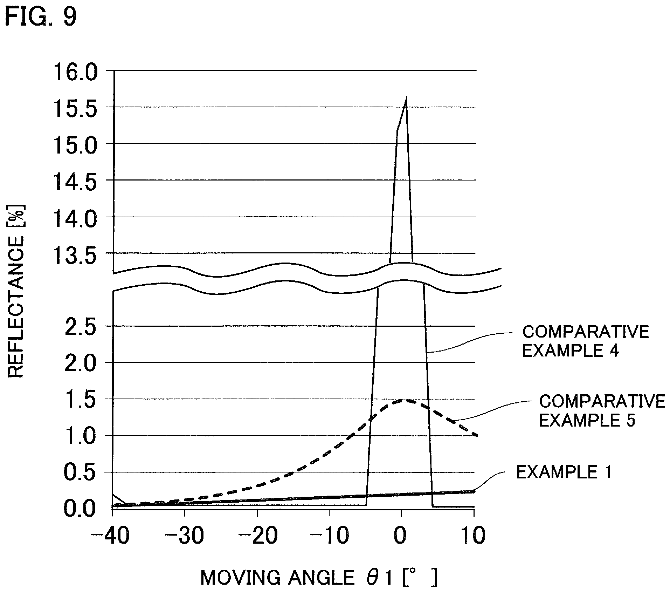

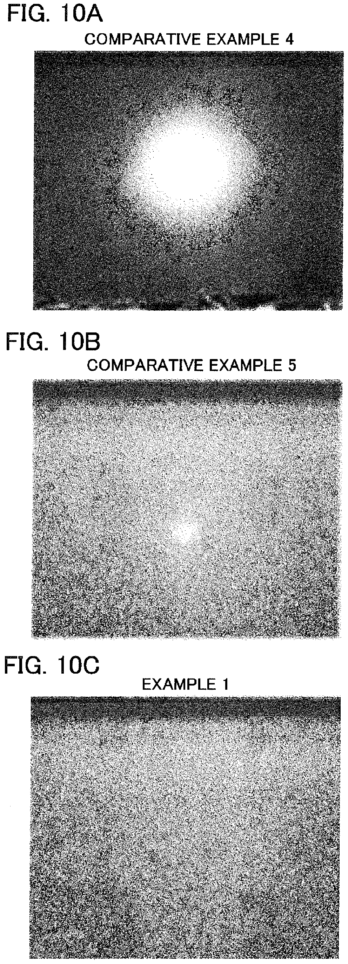

The measurement results are shown in Figs. 9 and 10.

The solar cell module of Comparative Example 4 which was not subjected to the anti-glare treatment had high reflectance near the moving angle of 0° (detection angle (reflection angle) of 60°) as shown in Fig. 9. In addition, the reflectance of the solar cell module in Comparative Example 4 was low within the range of not more than -5° and not less than 5°. It is found from this result that, in Comparative Example 4, the reflection light of emitted light mainly has regular reflection light components and less scattering light components.

In addition, the solar cell module of Comparative Example 5 having rough surface irregularities had lower reflectance than that of Comparative Example 4 near the moving angle of 0° (detection angle (reflection angle) of 60°) due to light dispersion, but this reflectance was still about 1.5%. It is found that, in Comparative Example 5, the reflection light of emitted light mainly has regular reflection light components, but still has a large amount of scattering light components.

On the other hand, the solar cell module of Example 1 had lower reflectance than the solar cell modules of Comparative Examples 4 and 5 near the moving angle of 0° (detection angle (reflection angle) of 60°). In addition, different from the solar cell modules of Comparative Examples 4 and 5, the solar cell module of Example 1 constantly had low reflectance at any angle.

It is considered that, in Example 1, the reflection light of emitted light is appropriately dispersed in regular reflection light components and scattering light components, resulting in that the reflectance is low at any detection angle (reflection angle).

As shown in Fig. 10A, in the solar cell module of Comparative Example 4, light was strongly reflected, and therefore, afterimage of light remained strong to clearly cause light glare. That is, when the light incidence surface (the irregular surface of the glass plate) was directly viewed, light was reflected to cause glare.

In addition, as shown in Fig. 10B, in the solar cell module of Comparative Example 5, afterimage of light remained to cause light glare. That is, when the light incidence surface (the irregular surface of the glass plate) was directly viewed, glare partially occurred thereon, although reflection of regular reflection light was lower than that of Comparative Example 4.

On the other hand, in the solar cell module of Example 1, afterimage of light did not occur as shown in Fig. 10C. That is, light glare did not occur, and glare was not caused. This shows that the solar cell module of Example 1 provides excellent anti-glare function.

### (Comparison in surface roughness of surface irregularities)

To derive a correlation between surface irregularities and reflectance, a plurality of samples were manufactured by changing the number count of white alumina, which was to be used in the irregularity forming process, so as to form different surface roughness, in accordance with the manufacturing process of the solar cell module of Example 1.

### (Example 2)

Among the manufactured samples, the one in which the surface roughness of the surface irregularities of the glass plate was within the range from 0.25 µm or more to 1.25 µm or less was defined as Example 2.

### (Comparative Example 6)

Among the manufactured samples, the one in which the surface roughness of the surface irregularities of the glass plate was less than 0.25 µm was defined as Comparative Example 6.

### (Comparative Example 7)

Among the manufactured samples, the one in which the surface roughness of the surface irregularities of the glass plate exceeded 1.25 µm was defined as Comparative Example 7.

The arithmetic mean roughness Sa was calculated using a laser microscope (Model No. OLS4000 manufactured by Olympus Corporation) for the solar cell module of Example 2, the solar cell module of Comparative Example 6, and the solar cell module of Comparative Example 7. In this case, the laser wavelength was 405 nm.

In addition, the 60° relative specular glossinesses, according to JIS Z 8741, of the glass plates were measured, and were used as a reference value for direct reflection. The device used for the measurement was a glossmeter (Model No. PG-II manufactured by Nippon Denshoku Industries Co., Ltd.).

In addition, the irregular surfaces 7 of the glass plates of the solar cell module of Example 2, the solar cell module of Comparative Example 6, and the solar cell module of Comparative Example 7 were irradiated with light from the normal direction, and the surfaces thereof were photographed by a camera.

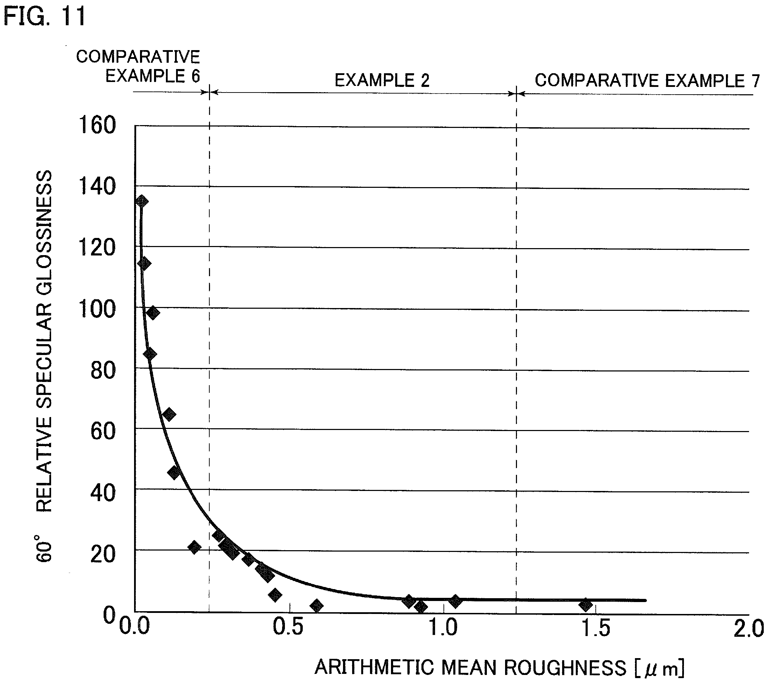

As shown in Fig. 11, the larger the arithmetic mean roughness was, the smaller the 60° relative specular glossiness was. Specifically, it is found that, the larger the arithmetic mean roughness of the glass plate is, the smaller the direct reflection amount of light incident at the incidence angle of 60° is.

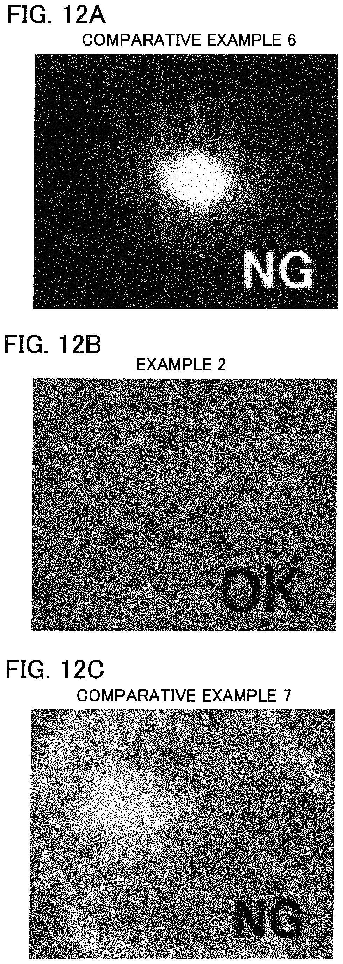

In addition, in the solar cell module of Comparative Example 6 where the surface roughness was less than 0.25 µm, the emitted light was reflected on the glass plate and light glare was clearly present on the glass plate as illustrated in Fig. 12A. Therefore, the solar cell module had the glaring irregular surface.

In the solar cell module of Example 2 in which the surface roughness was within the range from 0.25 µm or more and 1.25 µm or less, the emitted light was hardly reflected and light glare was not generated on the glass plate as illustrated in Fig. 12B. Therefore, glare did not occur.

In the solar cell module of Comparative Example 7 in which the surface roughness was larger than 1.25 µm, the emitted light was slightly reflected and light glare was generated a little on the glass plate as illustrated in Fig. 12C, although the surface roughness was larger than that of the solar cell module of Example 2. Therefore, glare occurred a little.

As described above, while the 60° relative specular glossiness was decreased with the increase in the surface irregularities 6, the light glare area was present within the range of that in Comparative Example 7, even if the 60° relative specular glossiness was small. This shows that the area where the light glare is not generated is not uniquely specified only by the roughness of the surface irregularities and the 60° relative specular glossiness.

Four samples having different 60° relative specular glossinesses were extracted from the result in Fig. 11, and we measured maximum reflectance Rmax, peak half-width H, reflectance R60 (incidence angle 60°/detection angle (reflection angle) 60°), and reflectance R45 (incidence angle 60°/detection angle (reflection angle) 45°) of these samples.

Specifically, two samples (Example 2-1, Example 2-2) were extracted from Example 2, one sample was extracted from Comparative Example 6, and one sample was extracted from Comparative Example 7, and each of them was subjected to the measurements. In addition, as Reference Example, two ceramic tiles (Reference Example 1-1 and Reference Example 1-2) having different 60° relative specular glossinesses were subjected to the measurements.

The maximum reflectance Rmax, the peak half-width H, the reflectance R60 (incidence angle 60°/detection angle (reflection angle) 60°), and reflectance R45 (incidence angle 60°/detection angle (reflection angle) 45°) were measured by using a goniophotometer (made by UV-VIS-NIR spectrophotometer V-670 and automated absolute reflectance measurement accessory ARMN-735) manufactured by JASCO Corporation. In addition, the measurement condition was set such that the wavelength of incident light was 550 nm, the incidence angle was fixed to 60°, and the moving angle was set to be within the range from -40° to 10° (detection angle (reflection angle) of 20° to 70°).

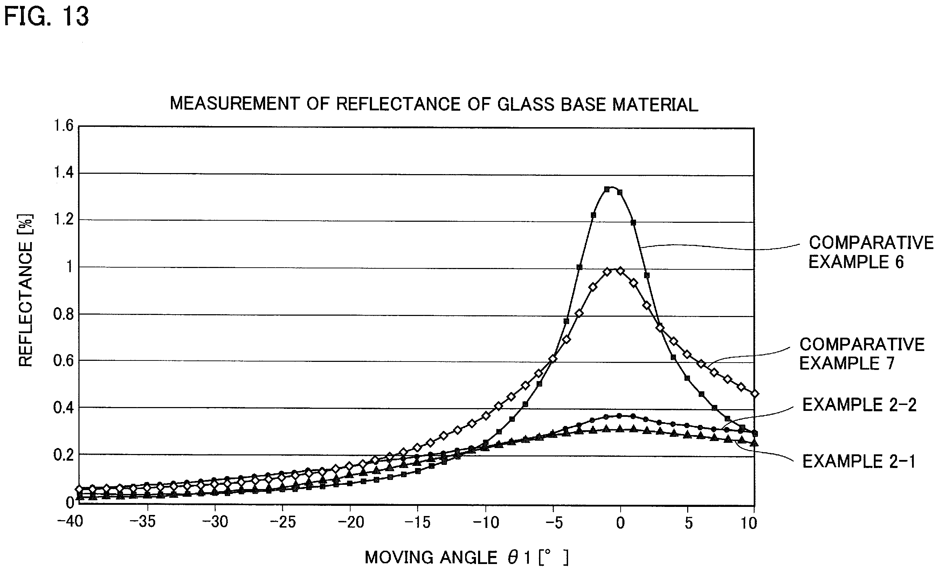

The measurement results are shown in Table 1 and Figs. 13, 14, 15, and 16.

**[Table 1]**

| | Material | Glossiness (60°) | Maximum reflectance (Incidence at 60°) | Peak half-width (Incidence at 60°) | R60/R45 | Visual (Light glare) |
|---|---|---|---|---|---|---|
| Example 2-1 | White plate glass | 2.6 | 0.326 | 34 | 1.21 | Absent |
| Example 2-1 | White plate glass | 4 | 0.377 | 32 | 1.43 | Absent |
| Comparative Example 6 | White plate glass | 10.5 | 1.342 | 8 | 4 | Present |
| Comparative Example 7 | White plate glass | 9.1 | 0.993 | 14 | 2.19 | Present |
| Reference Example 1-1 | Ceramic tile | 4 | 0.662 | 22 | 2.73 | Absent |
| Reference Example 1-1 | Ceramic tile | 6.5 | 0.794 | 26 | 2.36 | Absent |

As illustrated in Fig. 13, the solar cell module of Comparative Example 6 in which the surface roughness was less than 0.25 µm showed high reflectance near the moving angle of 0° (detection angle (reflection angle) of 60°) as illustrated in Fig. 13.

The solar cell module of Comparative Example 7 in which the surface roughness was larger than 1.25 µm showed lower reflectance than the solar cell module of Comparative Example 6 near the moving angle of 0° (detection angle (reflection angle) of 60°), but showed higher reflectance than the solar cell module of Comparative Example 6 within the range from -5° to -10°. This shows that the scattering light component in reflection light is larger in the solar cell module of Comparative Example 7 than that in the solar cell module of Comparative Example 6.

On the other hand, the solar cell module of Examples 2-1 and 2-2 showed lower reflectance than the solar cell modules of Comparative Examples 6 and 7 near the moving angle of 0° (detection angle (reflection angle) of 60°). In addition, different from the solar cell modules of Comparative Examples 6 and 7, the solar cell modules of Examples 2-1 and 2-2 constantly showed low reflectance at any angle. Specifically, in the solar cell modules of Examples 2-1 and 2-2, the regular reflection component and the scattering light component of the reflection light were both suppressed.

In addition, it is understood from Table 1 and Fig. 13 that the smaller the maximum peak height of the reflectance is and the larger the peak half-width is, the more difficult it is to cause light glare.

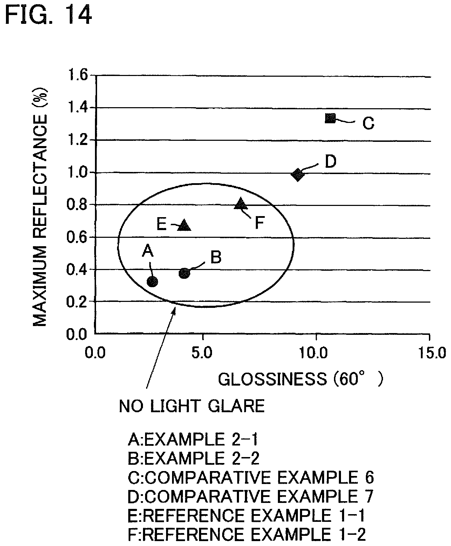

It is also understood from Table 1 and Fig. 14 that light glare is hardly generated in Examples 2-1 and 2-2 and Reference Examples 1-1 and 1-2 which are encircled by a solid line in Fig. 14 and in which the glossiness is small and the maximum reflectance is small.

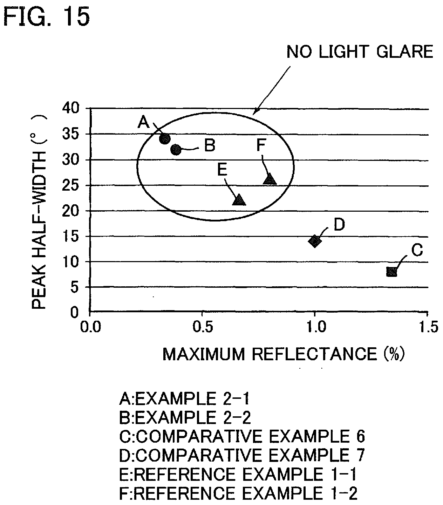

It is also understood from Table 1 and Fig. 15 that light glare is hardly generated in Examples 2-1 and 2-2 and Reference Examples 1-1 and 1-2 which are encircled by a solid line in Fig. 15 and in which the peak half-width is large and the maximum reflectance is small.

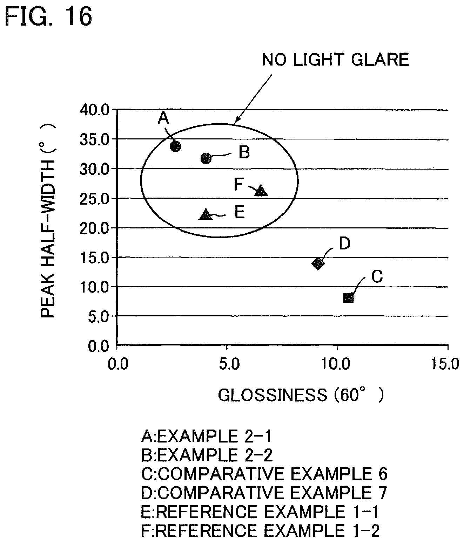

It is also understood from Table 1 and Fig. 16 that light glare is hardly generated in Examples 2-1 and 2-2 and Reference Examples 1-1 and 1-2 which are encircled by a solid line in Fig. 16 and in which the glossiness is small and the peak half-width is large.

It is found from the above that, in the light of the results in Examples 2-1 and 2-2 and Reference Examples 1-1 and 1-2, which have no light glare, a satisfactory anti-glare function can be provided by satisfying the condition in which at least the glossiness is not more than 6.5% and the maximum reflectance is not more than 0.8%.

### (Glare evaluation)

BGI (British Daylight Glare Index) was measured conforming to JIS Z 9125 by using the solar cell module of Example 1 subjected to the anti-glare treatment and the solar cell module of Comparative Example 4 not subjected to the anti-glare treatment.

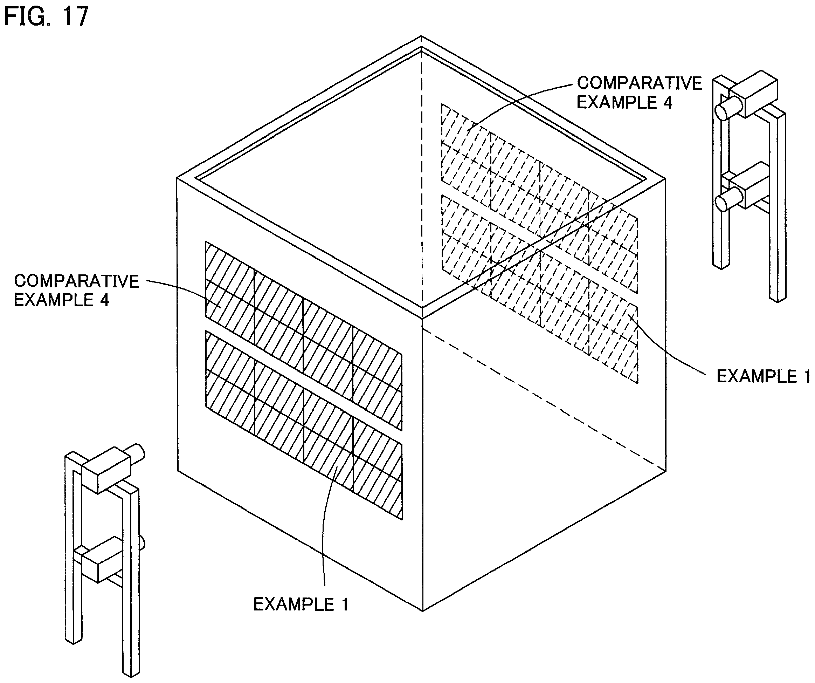

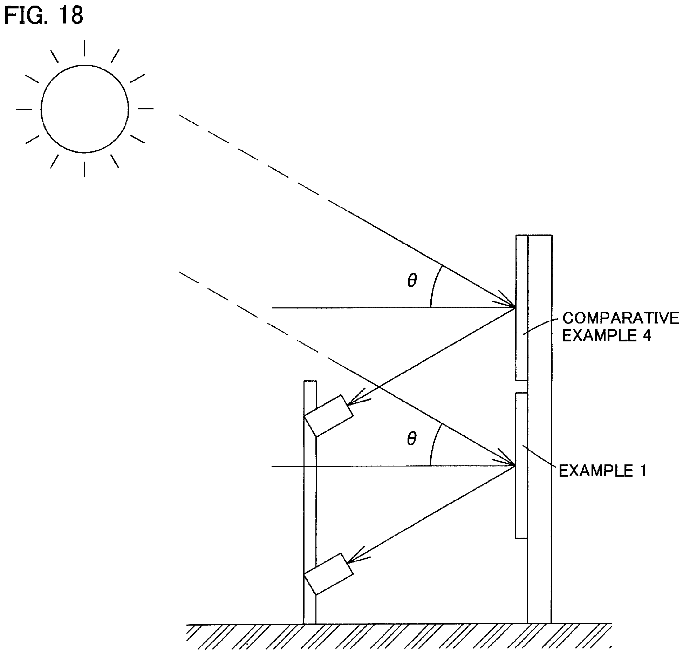

Specifically, on the site of Solar Energy Technology Center (Toyooka-City, at 35.5 degrees north latitude and 134.9 degrees east longitude) of Kaneka Corporation, wall surfaces erected upright with respect to the ground were set up in two orientations, east and west, the solar cell modules were installed on the respective wall surfaces, and the luminance distribution and average luminance of each solar cell module due to reflection of sunlight from each orientation were measured by a luminous distribution meter (Eye Scale One manufactured by I-system Co., Ltd.) as is understood from Figs. 17 and 18.

The reflection of sunlight on the solar cell module was supposed to be an ideal surface light source, a solid angle thereof was defined as π[sr], and the position index P thereof was defined as 1.5[m] supposing that a sight line faces the light source.

In addition, in consideration of the position of the sun, the solar cell module on the east side was measured at 9 a.m. and 10 a.m., and the solar cell module on the west side was measured at 2 p.m., 3 p.m., and 4 p.m. The incidence angle θ of the sunlight on the incidence surface of each solar cell module and detection angle at each time were as follows: 48.8° at 9 a.m., 60.61° at 10 a.m., 59.72° at 2 p.m., 47.86° at 3 p.m., and 35.69° at 4 p.m.

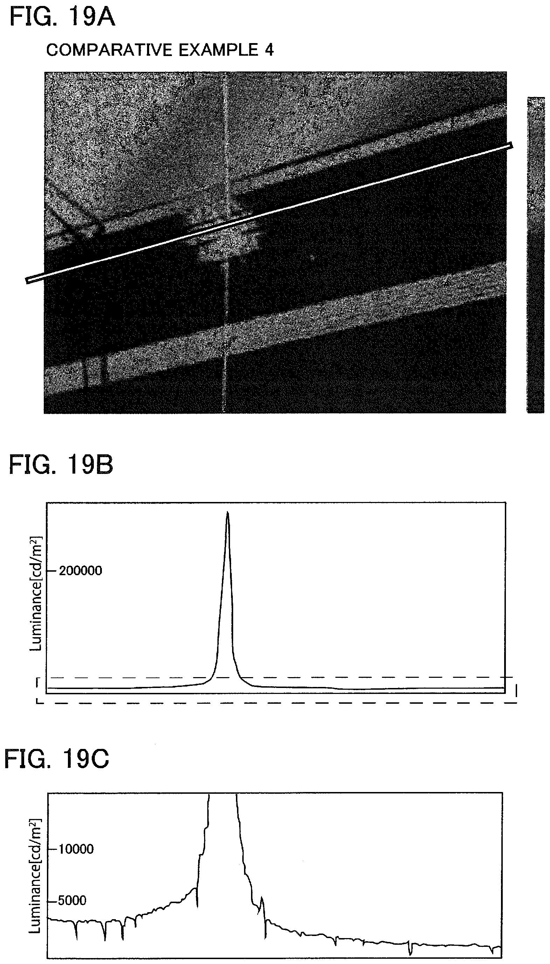

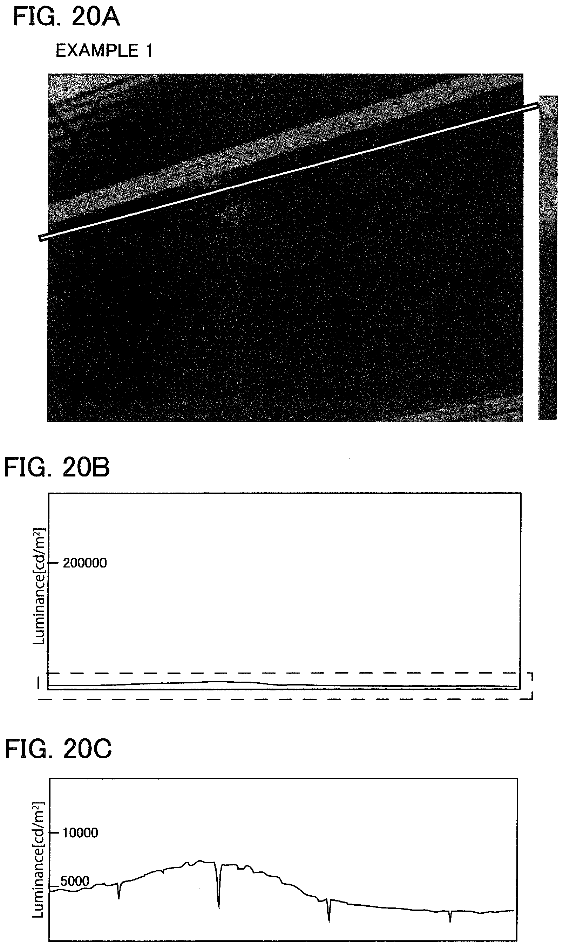

Figs. 19 and 20 show the measurement results of the solar cell modules in Comparative Example 4 and Example 1 at 4 p.m.

As shown in Fig. 19A, it is apparent from the photographed image by a CCD camera that the solar cell module of Comparative Example 4 has an area with high luminance due to the reflection of sunlight.

In the solar cell module of Comparative Example 4, the luminances in both the east and west orientations exceeded the detection limit of the luminance distribution meter, so that the BGI could not be calculated.

On the other hand, as shown in Fig. 20A, it is apparent from the photographed image by a CCD camera that the solar cell module of Example 1 has an area with high luminance due to the reflection of sunlight, but such area is small and luminance and contrast are also small.

In addition, it is understood from Figs. 19B and 19C which indicate the luminance on a white line in Fig. 19A and from Figs. 20B and 20C which indicate the luminance on a white line in Fig. 20A that the luminance of the solar cell module of Example 1 is smaller than that of the solar cell module of Comparative Example 4.

In addition, in the solar cell module of Example 1, the luminances in both the east and west orientations fell within the detection limit of the luminance distribution meter, and the BGI was not more than 18. Specifically, in the solar cell module of Example 1, the glare level fell below the standard BGI of 19 which is specified as "Unacceptable but not uncomfortable".

From the above, it is found that the solar cell module of Example 1 has an extremely higher anti-glare function than the solar cell module in Comparative Example 4, and even if sunlight is reflected, the reflection light is on the level of just acceptable but not uncomfortable.

As described above, it is found that a solar cell module having an extremely high anti-glare function and well adaptable as a wall mounted solar cell module can be manufactured by controlling various parameters.

### EXPLANATION OF REFERENCE SIGNS

- 1:: solar cell module
- 2:: glass substrate (glass plate)
- 3:: photoelectric conversion element
- 17:: antireflection film
- 20:: transparent electrode layer (electrode layer)
- 22:: back electrode layer (electrode layer)

## Claims

1. A solar cell module comprising: a glass plate having a macroscopically flat surface; and a photoelectric conversion element,
the solar cell module converting light to electricity by the photoelectric conversion element, the light being transmitted through the glass plate to be incident on the photoelectric conversion element, the glass plate having surface irregularities on a surface of an incidence side thereof,
wherein 60° relative specular glossiness conforming to JIS Z 8741 on a main surface of an incidence side of the solar cell module is not more than 6.5%, and
wherein maximum reflectance is not more than 0.8% when light is incident at an angle of 60° with respect to a normal of the main surface of the incidence side.

2. The solar cell module according to claim 1, wherein the 60° relative specular glossiness conforming to JIS Z 8741 on the main surface of the incidence side is not more than 4.1%.

3. The solar cell module according to claim 1 or 2, wherein the maximum reflectance is not more than 0.45% when light is incident at an angle of 60° with respect to the normal of the main surface of the incidence side.

4. The solar cell module according to any one of claims 1 to 3, wherein R60/R45 is not more than 2.7, the R60 being defined as reflectance at a reflection angle of 60° with respect to the normal of the main surface of the incidence side when light is incident at an angle of 60° with respect to the normal, the R45 being defined as reflectance at a reflection angle of with respect to the normal of the main surface of the incidence side when light is incident at an angle of 60° with respect to the normal.

5. The solar cell module according to claim 4, wherein the R60/R45 is not more than 2.0.

6. The solar cell module according to any one of claims 1 to 5, wherein arithmetic mean roughness on the surface of the incidence side of the glass plate is 0.25 µm or more and 1.25 µm or less.

7. The solar cell module according to claim 6, wherein the arithmetic mean roughness on the surface of the incidence side of the glass plate is 0.4 µm or more and 0.9 µm or less, and standard deviation thereof is 0.015 to 0.02.

8. The solar cell module according to any one of claims 1 to 7, wherein a half width to the maximum peak is not less than 22° when reflectance with respect to each reflection angle to light is graphically shown, the light being incident at an angle of 60° with respect to the normal of the main surface of the incidence side.

9. The solar cell module according to claim 8, wherein the half width to the maximum peak is not less than 29°.

10. The solar cell module according to any one of claims 1 to 9, wherein the glass plate supports the photoelectric conversion element including two electrode layers and a photoelectric conversion layer interposed between the two electrode layers, one of the two electrode layer being a transparent conductive film and facing the glass plate.

11. The solar cell module according to any one of claims 1 to 10,
wherein an antireflection film is provided on the surface of the incidence side of the glass plate, and
wherein refractive index of the antireflection film with respect to light having a wavelength of 600 nm is larger than 1 and not more than refractive index of the glass plate.

12. A solar cell module comprising: a glass plate having a macroscopically flat surface; and a photoelectric conversion element,
the solar cell module converting light to electricity by the photoelectric conversion element, the light being transmitted through the glass plate to be incident on the photoelectric conversion element, the glass plate having surface irregularities on a surface of an incidence side thereof,
wherein arithmetic mean roughness of the glass plate is 0.25 µm or more and 1.25 µm or less,
wherein 60° relative specular glossiness conforming to JIS Z 8741 on a main surface of an incidence side of the solar cell module is not more than 4.1 %,
wherein maximum reflectance is not more than 0.45% when light is incident at an angle of 60° with respect to a normal of the main surface of the incidence side, and
wherein R60/R45 is not more than 2.0, the R60 being defined as reflectance at a reflection angle of 60° with respect to the normal of the main surface of the incidence side when light is incident at an angle of 60° with respect to the normal, the R45 being defined as reflectance at a reflection angle of with respect to the normal of the main surface of the incidence side when light is incident at an angle of 60° with respect to the normal.
